(19) Europäisches Patentamt / European Patent Office / Office européen des brevets

(11) **EP 2 342 828 B1**

(12) **FASCICULE DE BREVET EUROPEEN**

(45) Date de publication et mention de la délivrance du brevet:
**01.03.2017 Bulletin 2017/09**

(51) Int Cl.:
*H03M 3/00* <sup>(2006.01)</sup>     *H03M 3/02* <sup>(2006.01)</sup>

(21) Numéro de dépôt: **09775123.4**

(22) Date de dépôt: **29.10.2009**

(86) Numéro de dépôt international:
**PCT/EP2009/064324**

(87) Numéro de publication internationale:
**WO 2010/049507 (06.05.2010 Gazette 2010/18)**

(54) **PROCÉDÉ D'AMELIORATION DE LA RESOLUTION ET DE CORRECTION DES DISTORSIONS POUR MODULATEUR SIGMA-DELTA ET MODULATEUR SIGMA-DELTA METTANT EN OEUVRE LE PROCÉDÉ**

VERFAHREN ZUR VERBESSERUNG DER AUFLÖSUNG UND KORREKTUR VON VERZERRUNGEN IN EINEM SIGMA-DELTA-MODULATOR UND DAS VERFAHREN IMPLEMENTIERENDER SIGMA-DELTA-MODULATOR

METHOD FOR IMPROVING THE RESOLUTION AND THE CORRECTION OF DISTORTIONS IN A SIGMA-DELTA MODULATOR, AND SIGMA-DELTA MODULATOR IMPLEMENTING SAID METHOD

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **31.10.2008 FR 0806079**

(43) Date de publication de la demande:
**13.07.2011 Bulletin 2011/28**

(73) Titulaire: **THALES**
**92400 Courbevoie (FR)**

(72) Inventeurs:
• **HODE, Jean-Michel**
  **F-92210 Saint Cloud (FR)**
• **KAMOUN, Leila**
  **F-92000 Nanterre (FR)**

(74) Mandataire: **Brunelli, Gérald et al**
**Marks & Clerk France**
**Immeuble Visium**
**22, avenue Aristide Briand**
**94117 Arcueil Cedex (FR)**

(56) Documents cités:
**FR-A1- 2 907 988     US-A- 5 838 272**
**US-A1- 2005 275 571**

• **PÉTER KISS ET AL: "Adaptive Digital Correction of Analog Errors in MASH ADC's-Part II: Correction Using Test-Signal Injection" IEEE TRANSACTIONS ON CIRCUITS AND SYSTEMS II: EXPRESS BRIEFS, IEEE SERVICE CENTER, NEW YORK, NY, US, vol. 47, no. 7, 1 juillet 2000 (2000-07-01), XP011013253 ISSN: 1057-7130**

EP 2 342 828 B1

**Description**

La présente invention concerne un procédé d'amélioration de la résolution et de correction des distorsions pour modulateur sigma-delta et un modulateur sigma-delta mettant en oeuvre le procédé. Elle s'applique notamment aux domaines du traitement du signal, de la conversion analogique-numérique et de l'électronique.

La conversion d'un signal analogique en un signal numérique est devenue une opération classique dans les circuits électroniques actuels, grâce à des composants standards du marché couramment regroupés sous l'acronyme CAN signifiant « Convertisseur Analogique-Numérique ». Il s'agit de représenter un signal e(t) variant de manière continue dans le temps et pouvant prendre n'importe quelle valeur sous une forme s(t) échantillonnée dans le temps. Chaque échantillon peut prendre un nombre fini de valeurs quantifiées possibles et chaque valeur est codée sur un nombre de bits bien déterminé. Chaque bit peut prendre uniquement deux valeurs possibles, 1 ou -1 par exemple.

Les CAN classiques offrent des performances en précision qui sont suffisantes à des fréquences relativement basses du signal d'entrée, de l'ordre de quelques dizaines voire centaines de mégahertz. Cela signifie qu'à ces fréquences, la différence entre le signal représenté numériquement en sortie et le signal analogique d'entrée est acceptable. Mais dans le domaine des hyperfréquences, lorsque la fréquence du signal d'entrée est de l'ordre de quelques gigahertz, la dynamique des CAN classiques, c'est-à-dire leur capacité à échantillonner/quantifier à la fois rapidement et précisément le signal d'entrée, s'avère nettement insuffisante. En premier lieu, ceci est du au temps de montée insuffisant d'un composant interne des CAN appelé échantillonneur/bloqueur. Un échantillonneur/bloqueur peut difficilement stabiliser un signal d'entrée en vue de le quantifier s'il est à trop haute fréquence, la durée requise pour cette stabilisation étant alors trop grande par rapport à la période d'échantillonnage. Ceci introduit des erreurs, c'est-à-dire que des échantillons numériques peuvent ne pas être représentatifs du signal analogique. Chaque échantillon ne peut alors être codé que sur un nombre réduit de valeurs d'amplitude. Intrinsèquement, cela génère une erreur due au manque de précision avant la quantification de l'amplitude de chaque échantillon. Par conséquent, l'erreur inhérente au procédé de numérisation d'un CAN classique à haute fréquence d'échantillonnage est la somme de l'erreur décrite, liée au défaut de rapidité de l'échantillonneur/bloqueur, et de l'erreur d'arrondi de quantification qui traduit la différence entre le signal ainsi échantillonné/bloqué et sa représentation numérique quantifiée. Cette erreur globale est abusivement appelée « bruit de quantification » car, dans la pratique, la partie liée à la quantification est majoritaire (du moins à basse fréquence). Ainsi, à fréquence élevée la différence entre le signal représenté numériquement en sortie et le signal analogique en entrée devient non négligeable et la précision du CAN n'est plus suffisante. En résumé, la précision des CAN classiques diminue quand la fréquence du signal analogique e(t) appliqué à leur entrée augmente. Ils ne sont donc pas adaptés à l'utilisation dans des applications à très hautes fréquences exigeant une bonne précision numérique, comme les radars par exemple.

Un procédé appelé modulation sigma-delta permet d'améliorer la précision d'un CAN localement autour d'une fréquence, éventuellement autour d'une fréquence élevée. Le principe de base est de faire varier arbitrairement le signal numérique de sortie, ou de le « moduler », de manière à minimiser l'erreur pour toute composante spectrale contenue dans la bande d'intérêt (qui dépend de l'utilisation), quitte à ce que des échantillons du signal numérique de sortie puissent sembler non représentatifs du signal analogique d'entrée. Pour cela, la modulation sigma-delta requiert par principe que le signal soit fortement sur-échantillonné, ce qui ne peut être fait que sur un petit nombre de bits. Cela revient à augmenter la précision temporelle en découpant le signal en un grand nombre d'échantillons mais, comme expliqué plus haut, au prix d'une diminution de la précision en amplitude du fait de l'augmentation de la fréquence d'échantillonnage. Mais en s'appuyant sur le sur-échantillonnage, le signal numérique de sortie peut être modulé afin de minimiser la puissance de ce bruit de quantification dans une bande de fréquence déterminée.

Dans le domaine fréquentiel ou spectral, il est couramment dit que la modulation Sigma-Delta « conforme » le bruit de quantification. En effet, la modulation du signal numérique de sortie, qui est adaptée à la fréquence du signal d'entrée, revient à minimiser la densité spectrale du bruit de quantification autour de la fréquence du signal utile. En fait, le spectre du bruit de quantification doit être rendu « conforme » à un spectre idéal présentant un creux au voisinage de la fréquence d'utilisation. Ainsi, même si un bruit de quantification globalement important est intrinsèquement généré en modulation Sigma-Delta, ceci quelle que soit la fréquence du signal en entrée, au moins ce bruit de quantification est de faible puissance au voisinage de la fréquence d'utilisation.

Un modulateur Sigma-Delta peut être mis en oeuvre à partir d'un convertisseur CAN asservi dans une boucle d'asservissement de manière classique, en vue d'atténuer l'influence de son bruit de quantification sur sa sortie numérique. Dans ce cas, un convertisseur numérique-analogique, appelé convertisseur CNA par la suite, permet de reconvertir en analogique le signal numérique de sortie du convertisseur CAN en vue de le soustraire au signal d'entrée, par principe de la boucle fermée d'asservissement. Un amplificateur et un filtre de boucle permettent de contourner l'inconvénient des CAN classiques en associant haute fréquence et fine résolution.

Outre le phénomène de défaut de rapidité observé à fréquence très élevée du signal d'entrée sur les échantillonneurs/bloqueurs d'un convertisseur CAN et auquel la modulation sigma-delta se propose d'apporter une réponse, un phénomène dit de « métastabilité » se pose à d'autres composants de ces convertisseurs, ces composants étant appelés comparateurs. La métastabilité est un phénomène connu d'indécision dans les convertisseurs CAN d'autant plus important que la fréquence d'échantillonnage augmente et donc que le temps de traitement diminue. Ce phénomène a toujours existé, mais avec l'augmentation de la vitesse de fonctionnement des circuits numériques actuels, il est passé du second au premier plan. A cause de ce phénomène, qui est détaillé par la suite, certains bits peuvent ne pas être décidés en sortie d'un convertisseur CAN dans un modulateur sigma-delta : ils ne valent ni -1 ni 1. Ce sont alors des couches logiques situées après les comparateurs du CAN qui lèvent ces indécisions. Or dans un modulateur sigma-delta de telles couches sont présentes à la fois dans le retour de boucle et dans le chemin de sortie. Ces couches qui sont physiquement différentes lèvent donc les indécisions de manière totalement indépendante, d'une part pour le signal numérique de sortie et d'autre part pour le signal numérique renvoyé vers l'entrée du modulateur. Ainsi rien ne garantit que les levées d'indécision soient cohérentes ou homogènes entre le signal numérique de sortie et le signal numérique renvoyé vers l'entrée. La différence entre ces deux signaux doit être considérée comme une erreur ajoutée.

Puisqu'il ramène le signal de sortie sur l'entrée, le convertisseur numérique-analogique CNA de retour de boucle doit présenter des performances en bruit et linéarité au moins aussi bonnes que les performances visées pour l'ensemble du modulateur car tout signal parasite, cohérent (raies parasites liées aux défauts de linéarité) ou incohérent (bruit ajouté, erreur de codage), généré dans le retour de boucle ne peut être comprimé par la boucle.

Dans la suite de la description les bits les moins significatifs, appelés également bits de poids faible, seront par la suite désignés par l'acronyme anglo-saxon LSB signifiant « Less Significant Bit ». D'autre part, les bits les plus significatifs, appelés également bits de poids fort, seront par la suite désignés par l'acronyme anglo-saxon MSB signifiant « Most Significant Bit ».

La logique de décodage du convertisseur CAN pouvant ne pas être suffisamment rapide pour ce qui concerne les bits LSB, il peut être préférable de ne reboucler qu'un certain nombre des bits MSB vers le convertisseur CNA de retour de boucle.

Dans ce cas on dispose en sortie de modulateur d'un signal numérique dont, d'une part, les bits MSB sont censés représenter le signal rebouclé pour lequel le bruit de quantification est mis en forme par la boucle et dont, d'autre part, les bits LSB représentent un codage du bruit de quantification non mis en forme par la boucle, codage présentant son propre bruit de quantification. En effet le convertisseur CAN peut-être considéré comme un système linéaire ajoutant un bruit, c'est-à-dire le bruit de quantification. La sortie du convertisseur CAN, sur $N_{MSB}+N_{LSB}$ bits au total, comporte $N_{MSB}$ bits MSB qui sont rebouclés dans le convertisseur CNA et $N_{LSB}$ bits LSB qui ne le sont pas. Les $N_{MSB}$ bits MSB portent donc le signal utile accompagné du bruit de quantification basse résolution $b_{MSB}$ conformé par la boucle. Les $N_{LSB}$ bits LSB fournissent un bruit correspondant à la différence $b_{LSB} - b_{MSB}$ non conformée entre les bruits de quantification haute et basse résolution $b_{MSB}$ et $b_{LSB}$.

Une amélioration possible visant à limiter les erreurs liées aux problèmes de métastabilité est de ré-échantillonner par un second CAN la sortie du convertisseur CNA de retour de boucle afin de disposer d'une deuxième information plus précise sur le signal effectivement rebouclé. A ce titre la sortie de nouveau CAN sera considérée comme la sortie principale du modulateur et celle du CAN de boucle comme la sortie secondaire. L'écart entre le signal principal et les bits MSB du signal secondaire est, par rapport aux bits LSB, une mesure complémentaire du bruit non remis en forme par la boucle. Il est donc possible de considérer que la sortie secondaire porte la somme du signal principal, de son bruit de quantification conformé, de l'opposé du bruit de quantification non conformé, du bruit de quantification $b_{LSB}$ et du bruit de métastabilité. La somme de ces deux dernières contributions peut être interprétée comme l'erreur d'estimation du bruit de quantification non conformé par le système. Si la réponse de la boucle est connue avec suffisamment de précision il est alors possible de tenir compte de l'information supplémentaire portée par le signal secondaire (bruit de quantification non conformé codé avec une erreur résiduelle) afin d'améliorer numériquement la résolution du modulateur.

Une possibilité pour améliorer ainsi la résolution à partir d'une mesure de l'erreur du modulateur est décrite dans la publication de T.C. Leslie et B. Singh intitulée An improved $\Sigma\Delta$ modulatorarchitecture, IEEE Proc. ISCAS'90, vol.1, pp. 372-375, Mai 1990. D'autres mises en oeuvre sont également décrites de façons différentes dans le livre Delta-Sigma Data Converters, IEEE Press, Ed. Norsworthy, Schreier & Temes, Ch 8, pp. 273-275 et dans le brevet américain N° 5838272 intitulé *Error correcting sigma-delta modulation decoding.* Ces publications montrent que d'une manière générale, à tout endroit du modulateur et de la chaîne de codage, le signal présent peut s'écrire comme une combinaison linéaire du signal et d'une erreur dont les coefficients dépendent de la fréquence. Il est donc possible par filtrage approprié et addition de corriger l'erreur en sortie.

Lorsque la fréquence de travail est très élevée, ces traitements deviennent difficiles à réaliser de par leur complexité car ceux-ci sont habituellement effectués avant l'opération de décimation. Il est donc nécessaire de trouver des solutions permettant d'améliorer la résolution des modulateurs sigma-delta fonctionnant à fréquence élevée sans pour autant alourdir l'architecture de traitement de façon inconsidérée.

Un autre modulateur sigma-delta est divulgué dans le document FR 2 907 988 A1.

Un but de l'invention est notamment de palier les inconvénients précités.

L'invention à pour objet un procédé selon la revendication 1.

La réponse temporelle $\xi_k(t)$ de la boucle ouverte du modulateur correspondant à une réponse fréquentielle $\xi_k(f)$ est mesurée, par exemple, pour différentes valeurs de retards de boucle supplémentaires en appliquant en entrée du convertisseur CNA de retour de boucle une série de $2^K \times M$ impulsions espacées régulièrement et permettant, en observant la sortie $\hat{s}(t)$ du modulateur après décimation, d'effectuer $2^K$ séries de M mesures successives de la réponse impulsionnelle correspondant à $2^K$ retards de boucle différents, ces M mesures successives étant ensuite moyennées pour fournir $2^K$ mesures de précision améliorée.

Selon un autre aspect de l'invention, un bruit b(t) d'amplitude crête égale à un bit LSB est ajouté pendant les mesures du gain de la boucle $\xi_k(t)$ en amont du convertisseur CAN produisant le signal numérique de sortie principale s(t).

Chacune des $2^K$ mesures des $2^K$ réponses $\xi_k(t)$ est, par exemple, filtrée par un filtre spécifique de réponse temporelle $J_k(t)$ et fréquentielle $J_k(f)$ destiné à compenser l'écart entre le retard de boucle correspondant à cette mesure de $\xi_k(t)$ et le retard de boucle correspondant à la mesure de $\xi_0(t)$.

Selon un mode de réalisation, les réponses $J_k(t)$ sont égales à $[\delta + k \times J /2^K]$ où $\delta$ est une réponse de Dirac et J une approximation finie d'un échantillonnage à $f_e/N$ de la dérivée du sinus cardinal sinc[$(f_e.t)/N$].

Selon un mode de réalisation, les $2^K$ mesures de la réponse $\xi_k(t)$ de la boucle après moyennage et interpolation sont pondérées par des coefficients valant $e^{j2\pi kf_0T_e/2^K}$ afin de produire une estimation de la réponse analogique en boucle ouverte $\xi(f)$ du modulateur.

Dans un mode de mise en oeuvre, le second traitement réalise un premier filtrage utilisant une réponse impulsionnelle correspondant à la réponse décimée $H_0(f)$ du traitement de démodulation/décimation, ledit filtrage étant appliqué au signal $\hat{s}(t)$ résultant de la démodulation/décimation de s(t), un second filtrage utilisant une réponse impulsionnelle correspondant à $\xi_0(f)$, ledit filtrage étant appliqué au signal $\hat{s}'(t)$ résultant de la démodulation/décimation de s'(t), un signal numérique r(t) de résolution amélioré est ensuite généré en additionnant les signaux résultants des deux opérations de filtrage.

Selon un aspect de l'invention, le troisième traitement réalise un filtrage principal suivi d'un filtrage complémentaire appliqués au signal r(t), le filtrage principal ayant une réponse impulsionnelle correspondant à l'inverse de la réponse fréquentielle $H_0(f).\xi(f)$ et le filtrage complémentaire ayant une réponse impulsionnelle correspondant à sinc[$(f+f_0)/f_e$] dans la bande utile du signal traité.

Selon un autre aspect de l'invention, la longueur de la réponse impulsionnelle du filtre complémentaire du traitement de correction des distorsions est réduite par raccordement du spectre dans le reste de la bande de Nyquist hors de la bande utile du signal traité.

L'invention a également pour objet un modulateur sigma-delta selon la revendication 10.

Dans un mode de mise en oeuvre, le modulateur sigma-delta comprend des moyens pour compenser des décentrages en phase de la boucle du modulateur, une commande numérique de contrôle de retard de la boucle étant déduite d'une comparaison entre une estimation de la réponse fréquentielle en boucle ouverte du modulateur et une réponse fréquentielle de référence.

Dans un autre mode de mise en oeuvre au moins un des modules de traitement du modulateur est instancié dans un circuit logique programmable de type FPGA.

D'autres caractéristiques et avantages de l'invention apparaitront à l'aide de la description qui suit donnée à titre illustratif et non limitatif, faite en regard des dessins annexés parmi lesquels :

- la figure 1 présente un exemple de modulateur sigma-delta en temps continu avec ré-échantillonnage de la voie de retour ;
- la figure 2 illustre le principe permettant l'amélioration de la résolution et de correction des distorsions selon l'invention ;
- la figure 3 présente une manière de mesurer la réponse en boucle ouverte d'un modulateur sigma delta ;
- la figure 4 présente un exemple de générateur d'impulsions pouvant être utilisé pour la mesure du gain de la boucle ouverte du modulateur ;
- la figure 5 présente une méthode permettant d'évaluer le gain de la boucle ouverte du modulateur et d'estimer la réponse analogique de la boucle ;
- la figure 6 donne un exemple de modulateur sigma-delta comportant un dispositif d'amélioration de la résolution et de correction des distorsions.

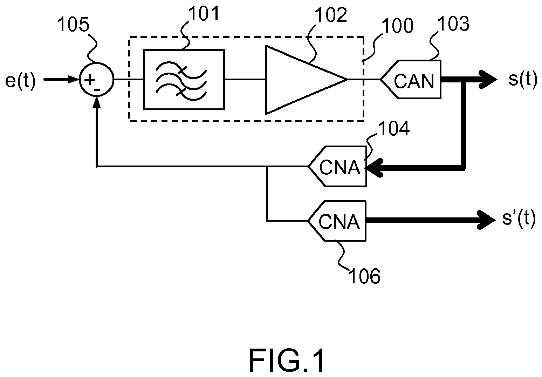

La figure 1 présente un exemple de modulateur sigma-delta en temps continu avec ré-échantillonnage de la voie de retour.

Comme explicité précédemment, le rôle d'un modulateur sigma-delta en temps continu est double. Un premier rôle est d'échantillonner et de numériser à fréquence d'échantillonnage élevée $f_e$ un signal analogique e(t) avec un nombre de bits faible, c'est-à-dire inférieur au nombre théorique requis pour atteindre un rapport signal sur bruit donné. Un second rôle est de mettre en forme le bruit de quantification de sorte que la densité spectrale de ce bruit dans la bande utile du signal à convertir soit compatible avec le rapport signal sur bruit visé après décimation. Pour cela, un modulateur sigma-delta passe-bande en temps continu est assimilable à une boucle d'asservissement. Un intégrateur 100 lui-même composé d'un filtre passe bande 101 et d'un amplificateur 102 a pour rôle d'intégrer et d'amplifier l'erreur dans la bande utile du signal. La boucle comprend un convertisseur CAN 103 produisant le signal numérique de sortie principale s(t) du modulateur représenté sur $N_B$ bits par échantillon. Ces $N_B$ bits peuvent être classés en deux groupes, soit $N_{MSB}$ bits MSB et $N_{LSB}$ bits LSB avec $N_B = N_{MSB} + N_{LSB}$. Le signal s(t) peut donc être décomposé de la manière suivante :

$$s(t) = s_{MSB}(t) + s_{LSB}(t) \qquad (1)$$

Comme explicité précédemment, il est intéressant de ne reboucler que les bits MSB, c'est-à-dire le signal numérique $s_{MSB}(t)$. Pour cela ces bits sont rebouclés vers un convertisseur CNA 104. Un additionneur-soustracteur 105 permettant d'évaluer la différence entre le signal d'entrée et le signal codé est placé en entrée du modulateur. Le signal est numérique entre la sortie du convertisseur CAN 103 et l'entrée du convertisseur CNA 104.

Un signal numérique s'(t) est généré en ré-échantillonnant la sortie du convertisseur CNA 104 de retour de boucle à l'aide d'un second convertisseur CAN 106 afin de disposer d'une deuxième information plus précise sur le signal effectivement rebouclé. Compte tenu de cela ce signal est considéré comme la sortie principale du modulateur.

Un signal h est par essence une grandeur physique h(t) variant dans le temps. Ce signal peut également être caractérisé par sa transformée de Fourier qui fournit sa décomposition spectrale en fréquence. Afin de simplifier la lecture des expressions dans la suite de la description, h(t) désignera le signal décrit dans le temps et h(f) sa transformée de Fourier.

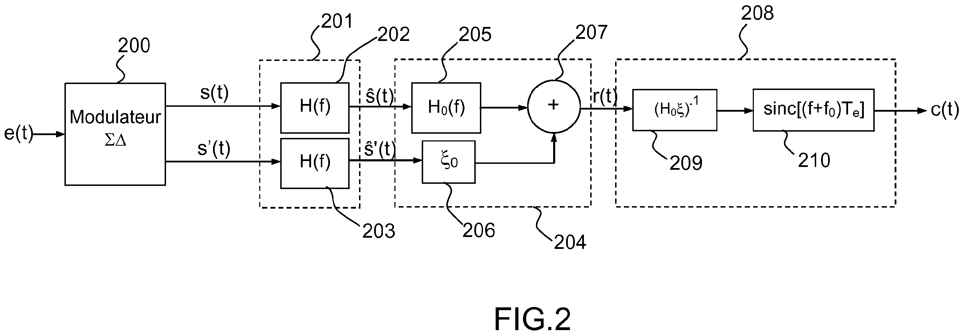

La figure 2 illustre le principe permettant l'amélioration de la résolution et la correction des distorsions selon l'invention.

Pour cela, trois traitements successifs sont appliqués sur les sorties s(t) et s'(t) d'une boucle de modulation sigma-delta 200 telle que décrite à l'aide de la figure 1. Ces trois traitements consistent en :

- un premier traitement 201 réalisant une démodulation et une décimation des sorties du modulateur 200 ;
- un second traitement 204 visant à l'amélioration de la résolution du signal converti ;
- un troisième traitement 208 dont le but est de corriger les distorsions introduites notamment par le filtre de décimation.

Le premier traitement 201 réalise les fonctions de filtre de décimation, c'est-à-dire qu'il élimine le signal dans les bandes repliées à cause de la décimation, ainsi que la décimation en tant que telle. Ce traitement est désigné dans la suite de la description par l'expression « traitement de démodulation/décimation ». Les signaux s(t) et s'(t) subissent chacun un traitement identique 202, 203 de filtrage et de décimation. La réponse impulsionnelle des deux traitements correspondant à une réponse fréquentielle H(f) est donc appliquée aux signaux s(t) et s'(t) de manière à générer respectivement deux sorties $\hat{s}(t)$ et $\hat{s}'(t)$, $\hat{s}(t)$ pouvant s'exprimer de la manière suivante :

$$\hat{s}(t) = \hat{s}_{MSB}(t) + \hat{s}_{LSB}(t) \qquad (2)$$

Le second traitement 204 améliore la résolution de la sortie principale du modulateur après filtrage et décimation $\hat{s}'(t)$ en utilisant l'information du signal rebouclé par le modulateur après filtrage et décimation $\hat{s}'(t)$. Ce traitement mène au signal r(t) défini selon l'expression suivante :

$$r(t) = \xi_0(f)\hat{s}'(f) + H_0(f)\hat{s}(f) \qquad (3)$$

$\xi_0(f)$ étant une estimation du gain en boucle ouverte du modulateur, gain mesuré entre l'entrée du convertisseur CNA de retour de boucle et la sortie du convertisseur CAN de boucle produisant le signal de sortie secondaire s(t). $H_0(f)$ représente la restriction à la bande décimée de la réponse H(f) du filtre de démodulation/décimation.

Le second traitement 204 consiste donc en un filtrage de s(t) par $H_0(f)$ 205 réalisé en parallèle d'un filtrage de s'(t) par $\xi_0(f)$ 206. Le signal de sortie r(t) résultant de ce second traitement est la somme 207 des résultats de ces deux opérations de filtrage.

De manière approchée, et en négligeant les effets du repliement de spectre et la réponse du CNA de retour de boucle, $\xi_0(f)$ est la restriction de G(f).H(f) à la bande décimée où G(f) est le gain de la boucle ouverte du modulateur. Toujours de manière approchée, il est connu que le gain de la boucle fermée est :

$$\frac{G(f)}{1+G(f)} \quad \text{sur le signal e} \qquad (4)$$

$$\frac{1}{1+G(f)} \quad \text{sur le bruit b} \qquad (5)$$

Comme indiqué plus haut, le signal de la sortie secondaire vaut :

$$S = s' - b + \text{erreurs} \qquad (6)$$

On en déduit facilement qu'avec le traitement :

$$G.s' + s = G.e + b - b + \text{erreurs} = G.e + \text{erreurs} \qquad (7)$$

et sans le traitement, dans la bande utile où G est grand :

$$G\,s' = G^2\,e\,/\,(1+G) + G\,b\,/\,(1+G) \approx G\,e + b \qquad (8)$$

Il apparait que le traitement a substitué les erreurs d'estimation du bruit de quantification au bruit de quantification lui-même, ce qui est, par principe, une amélioration de la résolution d'autant meilleure, en principe, que l'erreur est faible, c'est à dire que le nombre de LSB est grand.

Le troisième traitement 208 a pour but de corriger les distorsions introduites notamment par le filtre de décimation. Le signal r(t) résultant du traitement précédent 204 est traité afin de générer le signal de sortie c(t) s'exprimant de la manière suivante :

$$c(t) = \left[H_0(f)\xi(f)\right]^{-1}.\mathrm{sinc}\left[(f + f_0)T_e\right]r(t) \qquad (9)$$

la fonction sinc () étant définie par :

$$\mathrm{sinc}(z) = \frac{\sin(\pi z)}{\pi z} \qquad (10)$$

et $\xi(f)$ étant la réponse analogique en boucle ouverte du modulateur 200, c'est-à-dire la réponse entre son entrée (analogique) et la sortie (analogique) du CNA. Cette réponse ne pouvant être, dans la pratique, mesurée directement puisque seul son repliement lié à l'échantillonnage, est accessible via les données du CAN de boucle, elle est calculée à partir d'une série de $2^K$ mesures en utilisant l'expression suivante, qui constitue, pour chaque fréquence, en une transformation de Fourier discrète inverse (IFFT) :

$$\xi(f) = \frac{1}{2^K} \sum_{k=0}^{2^K-1} e^{jk 2\pi f_0 T_e/2^K} \xi_k(f) e^{jk 2\pi f T_e/2^K} \qquad (11)$$

ou $\xi_k(f)$ représente une mesure du gain de la boucle ouverte pour un retard de boucle supplémentaire de $k \times T_e/2^K$, mesure disponible après le traitement de démodulation et décimation 201. D'après la relation (9) ce troisième traitement est donc composé d'un filtrage par l'inverse de $H_0(f)\xi(f)$ 209 suivi de l'application de la fonction sinc[(f+f$_0$).T$_e$] 210.

L'amélioration de la résolution par le calcul en utilisant des données, de quelque origine qu'elles soient, de mesure du bruit de quantification ou de l'erreur commise, dépendent très largement de la précision avec laquelle est connue la réponse de la boucle. Il est donc important d'utiliser pour le traitement de correction des erreurs de codage (quantification ou autres) des réponses de filtres connues ou facilement mesurables et synthétisables avec suffisamment de précision. Ceci est d'autant plus vrai lorsqu'il s'agit de modulateurs en temps continu qui mélangent réponses en temps continu et réponses échantillonnées. Comme l'indiquent les relations (3) et (9), la présente invention a l'avantage de permettre de n'utiliser que de telles fonctions. De plus, les étapes d'amélioration de la résolution 204 et de correction des distorsions 208 opèrent après décimation 201, ce qui autorise une implémentation du procédé avec une complexité raisonnable lorsque la fréquence de travail du modulateur est élevée. Par ailleurs, l'ensemble de ces fonctions est accessible ou calculable en temps sans nécessité aucune de repasser en fréquence.

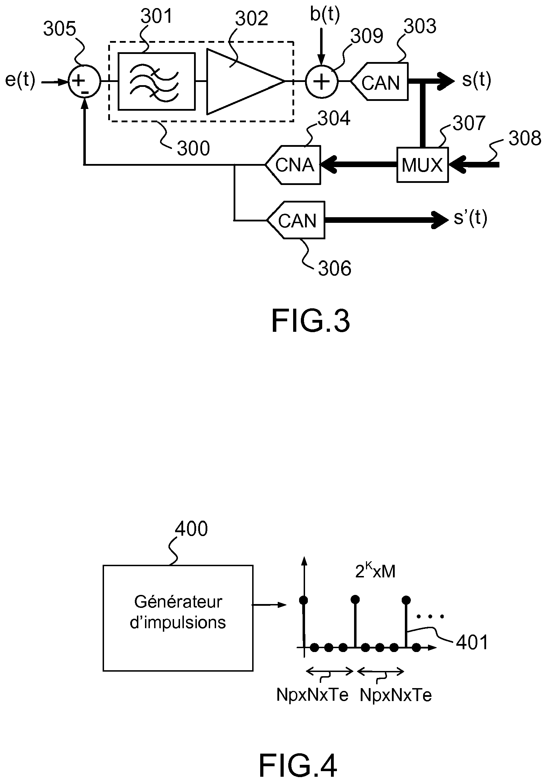

La figure 3 présente une manière de mesurer la réponse en boucle ouverte d'un modulateur sigma-delta.

La détermination des filtres présentés figure 2 requiert que la réponse en boucle ouverte du modulateur sigma-delta soit connue. Pour cela, il faut donc la mesurer. La boucle de conversion du modulateur est composée notamment d'un intégrateur 300 lui-même composé d'un filtre passe bande 301 et d'un amplificateur 302. La boucle comprend également un convertisseur CAN 303 produisant le signal numérique de sortie principale s(t) du modulateur. Les bits MSB de s(t) sont rebouclés vers un convertisseur CNA 304. Un additionneur-soustracteur 305 permettant d'évaluer la différence entre le signal d'entrée et le signal codé est placé en entrée du modulateur. Le signal numérique de sortie secondaire s'(t) est généré en ré-échantillonnant la sortie du convertisseur CNA 304 de retour de boucle à l'aide d'un second convertisseur CAN 306.

Par principe l'ouverture de la boucle s'effectue juste après la sortie de boucle, c'est à dire en entrée du convertisseur CNA 304 de retour de boucle. La mesure de cette réponse peut se réaliser soit directement en ouvrant la boucle, soit de manière indirecte en conservant la boucle fermée. Dans les deux cas cela nécessite d'injecter un signal 308 au niveau de l'entrée du convertisseur CNA 304. Pour cela il faut placer devant le CNA, par exemples, un multiplexeur statique 307 pour une mesure directe ou bien un sommateur pour une mesure indirecte. Le multiplexeur statique 307 n'a qu'un impact très limité sur la latence de la boucle. C'est pour cela que l'option de mesure directe en boucle ouverte est habituellement choisie. Dans la pratique ce n'est pas la réponse fréquentielle à réaliser qui est importante mais sa réponse impulsionnelle puisque le filtrage est mis en oeuvre par convolution dans le domaine temporel. En théorie, compte tenu de la nature du filtrage de boucle, la réponse de la boucle ouverte est une réponse de durée infinie mais sa décroissance est telle qu'il est possible de la tronquer et de l'assimiler à une réponse de durée finie. Cette réponse se mesure facilement en injectant une impulsion sur le convertisseur CNA 304 et en recueillant les informations disponibles en sortie après les éventuelles étapes de démodulation/décimation.

Comme la sortie du convertisseur CAN 304 est quantifiée sur un nombre de bits par définition assez faible, la précision d'une telle mesure n'est pas bonne. Il est alors possible de refaire la même mesure à intervalles réguliers, les intervalles étant supérieurs à la durée de la réponse tronquée, et d'effectuer une moyenne. Pour que cette moyenne soit effective, il est nécessaire que les mesures soient différentes. Pour cela, on ajoute 309 en amont de convertisseur CAN 303 de la boucle, par exemple, un léger bruit b(t). Ce bruit b(t) est, par exemple, à histogramme plat et d'amplitude crête égale à 1 bit LSB. Le nombre de mesures à moyenner dépend du nombre de bits disponibles pour la mesure. Par exemple, pour 6 bits, 16 à 32 mesures peuvent convenir.

Cette mesure fournit directement les coefficients recherchés du filtre transversal approchant la réponse $\xi_0(f)$ de la boucle ouverte après démodulation, filtrage et décimation à la fréquence d'échantillonnage de la sortie du traitement de démodulation/décimation.

La figure 4 présente un exemple de générateur d'impulsions 400 pouvant être utilisé pour la mesure du gain de la boucle ouverte du modulateur. Celui-ci permet de générer $2^K$ séries de M impulsions permettant d'effectuer $2^K$ séries de M mesures successives de la réponse impulsionnelle du modulateur en boucle ouverte moyennées pour obtenir $2^K$ mesures $\xi_k(t)$ pour $0 \leq k \leq 2^K-1$ correspondant à $2^K$ retards de boucle différents. Ces impulsions sont dirigées vers le convertisseur CNA de retour de boucle. Chaque impulsion 401 est espacée de ses impulsions voisines, par exemple, de $N_p \times N$ périodes d'horloge d'échantillonnage, N étant le rang de la décimation et $N_p$ le nombre d'échantillons maximum de la réponse impulsionnelle à mesurer. L'espacement entre les impulsions doit être choisi suffisamment grand pour isoler les mesures successives de la réponse de la boucle destinée à être ensuite moyennées.

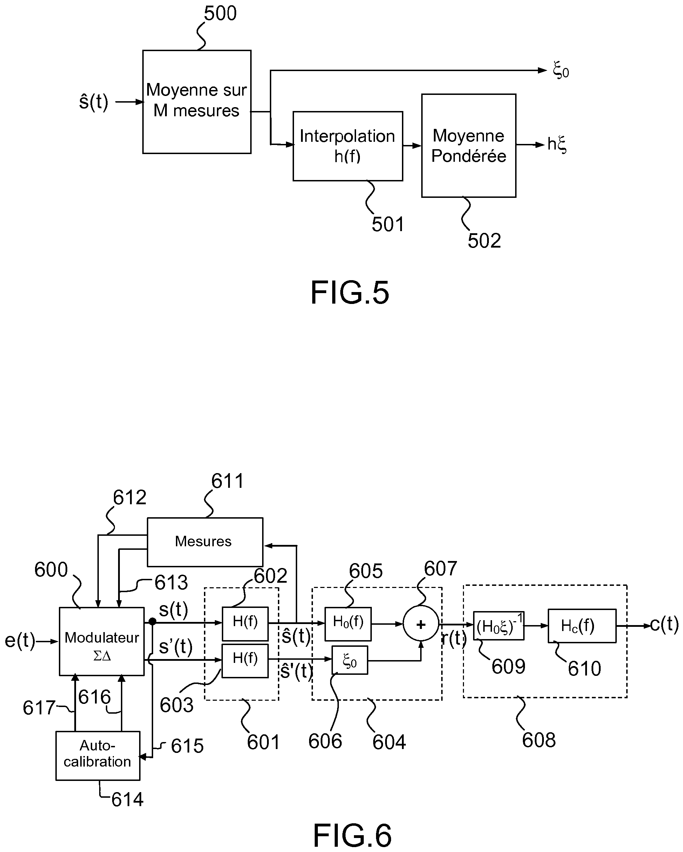

La figure 5 présente une méthode permettant d'évaluer le gain $\xi_k(f)$ (pour $0 \leq k \leq 2^K-1$) de la boucle ouverte du modulateur et d'estimer la réponse analogique $\xi(f)$, cette dernière réponse devant être connue afin d'améliorer la résolution et de corriger les distorsions en sortie du modulateur lorsque le procédé selon l'invention est utilisé.

La réponse analogique $\xi(f)$ est obtenue grâce à une moyenne pondérée des $2^K$ mesures $\xi_k(f)$ effectuées avec des retards en progression arithmétique de $\theta$ à $\theta+(1-2^{-K})T_e$. Comme la mesure de $\xi_0(f)$ décrite précédemment, ces mesures de $\xi_k(f)$ sont obtenues naturellement dans le domaine temporel à un taux d'échantillonnage plus lent que la fréquence d'horloge $f_e=1/T_e$ du fait du traitement de décimation. Or, dans la moyenne pondérée, la pondération de $\xi_k(f)$ par $e^{j2\pi kfT_e/2K}$ correspond, dans le domaine temporel, à décaler $\xi_k(t)$ de $-k.T_e/2^K$, c'est à dire d'une valeur bien plus fine que la période d'échantillonnage. Pour rester dans le domaine temporel il serait donc nécessaire d'effectuer une interpolation pour restituer la valeur utile, ce filtre d'interpolation devant être échantillonné à la fréquence $f_{ech} = 2^K \times f_e$ où $f_e$ est la fréquence d'échantillonnage du CAN de boucle. Ceci serait très consommateur en termes de ressources de calcul alors que n'est conservée, au bout du compte, qu'une information décimée. Il est donc nécessaire de transformer cette partie de traitement pour la rendre plus facile à réaliser.

Pour contourner le problème et éviter ce sur-échantillonnage, une solution originale consiste à ré-écrire le formalisme décrivant le sur-échantillonnage puis la décimation des réponses $\xi_k$ dont le spectre a été transposé au voisinage du continu par l'opération de démodulation.

L'interpolation des signaux $\xi_k$ de $f_e/N$ à $2^K.f_e$ peut se décomposer en deux opérations d'interpolation distinctes :

- une première interpolation par N suivie d'une seconde interpolation par $2^K$, l'ensemble ayant une réponse temporelle notée I. Dans ce qui suit, on comptera le temps en multiples de $1/f_e$ où $f_e$ est la fréquence d'échantillonnage du CAN de boucle et la notation $X_k$ définie par $X_k = I \otimes \xi_k$ est utilisée.
- une deuxième interpolation s'opère sur un signal échantillonné dont la cadence est N fois supérieure à la cadence de Nyquist.

La deuxième interpolation peut être approchée, sans erreur notable, par une interpolation linéaire :

$$Y_k(n) \approx X_k(n+k/2^K) \approx X_k(n) + k \times [X_k(n)-X_k(n-1)] /2^K \qquad (12)$$

c'est-à-dire :

$$Y_k(n) \approx X_k(n) + k \times X'_k(n) /2^K = [I \otimes \xi_k] (n) + k \times [I' \otimes \xi_k](n) /2^K \quad (13)$$

Soit après convolution par la réponse impulsionnelle H du post-traitement de décimation/démodulation :

$$H \otimes Y_k \approx H \otimes [I \otimes \xi_k] + k \times H \otimes [I' \otimes \xi_k] /2^K \qquad (14)$$

c'est-à-dire :

$$H \otimes Y_k \approx [I \otimes H \otimes \xi_k] + k \times [I' \otimes H \otimes \xi_k] /2^K \qquad (15)$$

Or $\xi_k$ est une réponse sous-échantillonnée par la décimation. $H_0$ correspondant à la restriction de H à la bande décimée, c'est à dire à un sous-échantillonnage de H, on a donc finalement, dans le domaine temporel, pour les différents termes fréquentiels correspondant à la somme de Fourier de l'IFFT de la relation (11) :

$$H \otimes Y_k \approx Z_k = H_0 \otimes [\xi_k + k \times J \otimes \xi_k /2^K] \qquad (16)$$

où J représente le sous-échantillonnage de I' par N x $2^K$.

La réponse $H_0(t) \otimes \xi(t)$ de spectre $H_0(f) \xi(f)$ sera finalement obtenue en effectuant une moyenne pondérée par $e^{j2\pi k f_0 T_e/2^K}$ des $2^K$ réponses $Z_k$. Il est ainsi possible d'éviter le sur-échantillonnage des calculs.

Le filtre d'interpolation I est par définition un sinus cardinal dont la réponse est cependant infinie :

$$I = sinc(f / f_{ech}) = sinc(f / f_e / 2^K) \qquad (17)$$

Dans la pratique, il faut alors limiter la durée de sa dérivée et à la pondérer pour limiter les effets de la troncature. La durée de J est, par exemple, ajustée pour ne pas dégrader le résultat dans la bande.

Afin de synthétiser la réponse $H_0(f) \xi(f)$, les opérations suivantes peuvent être conduites :

- une série de $2^K \times M$ impulsions, comme illustrée avec la figure 4, est appliquée en entrée du convertisseur CNA de retour de boucle du modulateur permettant la conduite de $2^K$ séries de M mesures successives de réponses impulsionnelles de $N_p$ points. Chacune des séries de mesures correspond à une valeur de retard de boucle différente $\theta + k \times T_e/2^K$ ($0 \le k \le 2^K$-1) où $\theta$ est le retard de boucle nominal ;
- ces séries de M mesures sont moyennées 500 pour fournir $2^K$ mesures de $\xi_k(t)$ avec une précision améliorée ; par conséquent, la réponse $\xi_0(t)$ est disponible et utilisable suite à cette opération de moyennage ;
- les $2^K$ mesures de $\xi_k(t)$ sont ensuite filtrées par un filtre de réponse $J_k$ égale à $J_k = [\delta + k \times J /2^K]$ où $\delta$ est une réponse de Dirac, nulle partout sauf au centre de la réponse, et J une approximation finie d'un échantillonnage à

$f_e/N$ de la dérivée du sinus cardinal $sinc[(f_e.t)/N]$. Une moyenne pondérée par $e^{j2\pi kf_0T_e/2K}$ 502 est conduite sur les $2^K$ réponses ainsi filtrées.

La figure 6 donne un exemple de modulateur sigma-delta comportant un dispositif d'amélioration de la résolution et de correction des distorsions.

Le modulateur comprend une boucle de conversion sigma-delta et des moyens pour améliorer la résolution et corriger les distorsions en sortie du modulateur. La figure reprend les éléments précédemment décrits à l'aide de la figure 2 tout en faisant apparaitre un module dit d'auto-calibration 611 dont le rôle est notamment de mesurer la réponse du modulateur en boucle ouverte. Ce module peut également être en charge du réglage automatique de la boucle de manière à compenser les décentrages en phase et en amplitude de la boucle.

Le dispositif comprend donc une boucle de conversion réalisant la modulation sigma-delta 600 prenant en entrée un signal analogique e(t) et générant deux sorties s(t) et s'(t). Le signal numérique s (t) est la sortie secondaire du modulateur sigma-delta. Ledit signal est un signal numérique représenté sur $N = N_{MSB} + N_{LSB}$ bits par échantillon. Le signal numérique de sortie principal s(t) représenté sur $N_{MSB}$ bits est généré suite au ré-échantillonnage de la sortie du convertisseur CNA de retour de boucle.

Le dispositif comprend en outre un premier module de traitement 601 réalisant les opérations de décimation/démodulation en appliquant la même opération de filtrage H(f) 602, 603 aux signaux de sortie s(t) et s'(t) du modulateur produisant respectivement les signaux $\hat{s}(t)$ et $\hat{s}'(t)$.

Les deuxième 604 et troisième 608 modules de traitement doivent, pour fonctionner correctement, avoir à leur disposition une estimation de la réponse de la boucle du modulateur sigma delta tenant compte de la décimation 601. Un module de mesure 611 est notamment chargé de cette estimation. Afin de la mener, le module de mesure 611 comprend, par exemple, un générateur d'impulsions tel que décrit précédemment. Le train d'impulsions résultant est mis en entrée 613 du convertisseur CNA de retour de la boucle de conversion 600 à l'aide, par exemple, d'un multiplexeur. Le signal résultant $\hat{s}(t)$ disponible en sortie du module de décimation/démodulation 601 est utilisé en entrée du module de mesures 611. Les réponses $\xi_0(t)$ et $H_0(t) \otimes \xi(t)$ sont estimées, par exemple, en appliquant la méthode explicitée précédemment avec la figure 5.

Un module d'auto-calibration 614 peut permettre également de compenser les décentrages en phase et en amplitude de la boucle de conversion 600 du modulateur. La réponse fréquentielle en boucle ouverte est estimée, par exemple, à l'aide d'un analyseur de réseau numérique injectant un signal stimuli 616 dans la boucle de conversion 600 pour ensuite analyser le signal s(t) 615 résultant dudit stimuli. La réponse fréquentielle ainsi estimée est ensuite comparée à une réponse de référence. Suite à cette comparaison, des commandes de contrôle 617 de la boucle du modulateur sont générées. Pour la correction des décentrages en phase, une commande de retard de boucle permet, par exemple, d'ajuster la phase relative entre les signaux d'horloge des convertisseurs CAN et CNA de la boucle. Les résultats $\xi_k(t)$ du module de mesures 614 peuvent être notamment utilisés afin d'incrémenter la commande de retard de boucle. Le décentrage en amplitude de la boucle peut être ainsi corrigé en appliquant, par exemple, une tension de commande à l'amplificateur, cette tension étant proportionnelle à l'erreur d'amplitude à compenser. Dans ce cas, un amplificateur à gain variable est nécessaire au modulateur sigma-delta.

Un second module de traitement 604 prenant en entrée les signaux $\hat{s}(t)$ et $\hat{s}'(t)$ vise à améliorer la résolution de la sortie du modulateur après décimation. Pour cela, deux filtrages de réponses temporelles correspondants à $H_0(f)$ 605 et $\xi_0(f)$ 606 sont appliqués respectivement aux signaux $\hat{s}(t)$ et $\hat{s}'(t)$. Les signaux résultants de ces deux opérations de filtrage sont ensuite additionnés 607 afin de générer le signal de sortie r(t) du module.

Un troisième module de traitement 608 prenant en entrée le signal r(t) a pour but de corriger les distorsions. Le signal r(t) est traité successivement par deux filtres : un filtre principal 609 de réponse fréquentielle $[H_0(f).\xi(f)]^{-1}$ et un filtre complémentaire 610 de réponse $H_c(f)$ menant au signal c(t) de sortie du dispositif. La réponse du filtre complémentaire 610 a une réponse temporelle coïncidant avec $sinc[(f+f_0)T_e]$ dans la bande utile et présentant un raccordement dans le reste de la bande de Nyquist destiné à réduire la longueur de sa réponse temporelle.

## Revendications

1. Procédé d'amélioration de la résolution et de correction des distorsions pour un modulateur sigma-delta, le modulateur (200) convertissant un signal d'entrée analogique e(t) en un signal numérique de sortie secondaire s(t) échantillonné à une fréquence $f_e$ et codé sur $N_B = N_{MSB} + N_{LSB}$ bits dont $N_{MSB}$ bits de poids fort MSB et $N_{LSB}$ bits de poids faible LSB, les $N_{MSB}$ bits MSB étant rebouclés dans le modulateur, le signal rebouclé après conversion numérique-analogique des $N_{MSB}$ bits de poids fort MSB étant ré-échantillonné à la fréquence $f_e$ de manière à générer un second signal numérique de sortie principale s'(t) représenté sur $N_{MSB}$ bits, le procédé étant **caractérisé en ce qu'**au moins trois traitements sont successivement appliqués en sortie du modulateur :

- un premier traitement (201) réalise une démodulation par une fréquence $f_0$ et une décimation de facteur N de manière indépendante (202, 203) sur les deux signaux s(t) et s'(t) ;
- un second traitement (204) d'amélioration de la résolution est appliqué au résultat du premier traitement (201) et un troisième traitement (208) de correction des distorsions est appliqué au résultat du second traitement (204), le second et le troisième traitements comportant des opérations de filtrage dont les réponses impulsionnelles sont dérivées de l'estimation $\xi_0(t)$ de la réponse analogique en boucle ouverte $\xi(t)$ du modulateur à partir de mesures de la réponse impulsionnelle en boucle ouverte $\xi_k(t)$, lesdites mesures ayant été réalisées en sortie du traitement de démodulation et décimation (201).

2. Procédé selon la revendication 1 **caractérisé en ce que** la réponse temporelle $\xi_k(t)$ de la boucle ouverte du modulateur correspondant à une réponse fréquentielle $\xi_k(f)$ est mesurée pour différentes valeurs de retards de boucle supplémentaires en appliquant en entrée du convertisseur CNA de retour de boucle (304) une série de $2^K \times M$ impulsions (308, 401) espacées régulièrement et permettant, en observant un signal de sortie $\hat{s}(t)$ issu du premier traitement (201), ledit signal résultant de la décimation, d'effectuer $2^K$ séries de M mesures successives de la réponse impulsionnelle correspondant à $2^K$ retards de boucle différents, ces M mesures successives étant ensuite moyennées (500) pour fournir $2^K$ mesures de précision améliorée.

3. Procédé selon la revendication 2 **caractérisé en ce qu'**un bruit b(t) d'amplitude crête égale à un bit LSB est ajouté (309) pendant les mesures du gain de la boucle $\xi_k(t)$ en amont du convertisseur CAN (303) produisant le signal numérique de sortie principale s(t).

4. Procédé selon l'une quelconque des revendications 2 ou 3 **caractérisé en ce que** chacune des $2^K$ mesures des $2^K$ réponses $\xi_k(t)$ est filtrée par un filtre spécifique de réponse temporelle $J_k(t)$ et fréquentielle $J_k(f)$ destiné à compenser l'écart entre le retard de boucle correspondant à cette mesure de $\xi_k(t)$ et le retard de boucle correspondant à la mesure de $\xi_0(t)$.

5. Procédé selon la revendication 4 **caractérisé en ce que** les réponses $J_k(t)$ sont égales à $[\delta + k \times J /2^K]$ où $\delta$ est une réponse de Dirac et J une approximation finie d'un échantillonnage à $f_e/N$ de la dérivée du sinus cardinal sinc$[(f_e.t)/N]$.

6. Procédé selon l'une quelconque des revendications 4 ou 5 **caractérisé en ce que** les $2^K$ mesures de la réponse $\xi_k(t)$ de la boucle après moyennage (500) et interpolation (501) sont pondérées (502) par des coefficients valant $e^{j2\pi kf_0Te/2K}$ afin de produire une estimation de la réponse fréquentielle analogique en boucle ouverte $\xi(f)$ du modulateur.

7. Procédé selon l'une quelconque des revendications précédentes **caractérisé en ce que** le second traitement (204) réalise un premier filtrage (205) utilisant une réponse impulsionnelle correspondant à une réponse décimée $H_0(f)$ du traitement de démodulation/décimation (201), ledit filtrage étant appliqué au signal $\hat{s}(t)$ résultant de la démodulation/décimation (202) de s(t), un second filtrage (206) utilisant une réponse impulsionnelle égale à $\xi_0(t)$, ledit filtrage étant appliqué au signal $\hat{s}'(t)$ résultant de la démodulation/décimation (203) de s'(t), un signal numérique r(t) de résolution amélioré est ensuite généré en additionnant (207) les signaux résultants des deux opérations de filtrage.

8. Procédé selon l'une quelconque des revendications précédentes **caractérisé en ce que** le troisième traitement (208) comprend un filtre principal (209) suivi d'un filtrage complémentaire (210) appliqués au signal r(t), le filtre principal ayant une réponse impulsionnelle correspondant à l'inverse de la réponse fréquentielle $H_0(f).\xi(f)$ et le filtre complémentaire ayant une réponse impulsionnelle correspondant à sinc$[(f+f_0)/f_e]$ dans la bande utile du signal traité.

9. Procédé selon la revendication 8 **caractérisé en ce que** la longueur de la réponse impulsionnelle du filtre complémentaire du traitement de correction des distorsions est réduite par raccordement du spectre dans le reste de la bande de Nyquist hors de la bande utile du signal traité.

10. Modulateur sigma-delta comportant au moins une boucle de conversion (600) convertissant un signal analogique e(t) en un signal numérique de sortie s(t), la boucle étant composée d'au moins un intégrateur (100), un premier convertisseur analogique-numérique CAN (103) générant un signal de sortie s(t), un convertisseur numérique-analogique CNA (104) de retour de boucle, un additionneur-soustracteur (105) et un second convertisseur analogique-numérique CAN (106) ré-échantillonnant la sortie du convertisseur de retour de boucle et générant un deuxième signal numérique de sortie s'(t), le modulateur étant **caractérisé en ce qu'**il comporte un dispositif d'amélioration de la résolution et de correction des distorsions mettant en oeuvre le procédé selon l'une des revendications précédentes et composé d'au moins :

- un module de modulation/décimation (601) traitant par filtrages indépendants les signaux s(t) et s'(t) de manière à générer au moins deux signaux de sortie ŝ(t) et ŝ'(t);
- un module d'amélioration de la résolution (604) filtrant les signaux ŝ(t) et ŝ'(t) de manière à produire un signal numérique de sortie r(t) ;
- un module de correction des distorsions (608) filtrant le signal r(t) et produisant le signal numérique de sortie c(t) du modulateur sigma-delta ;
- un module de mesure (611) de réponses numériques en boucle ouverte $\xi_k$(t) de la boucle de conversion (600) déduisant la réponse analogique en boucle ouverte $\xi$(t) desdites mesures afin de calibrer les réponses impulsionnelles de filtres compris dans les modules d'amélioration de la résolution (604) et de correction des distorsions (608).

**11.** Modulateur sigma-delta selon la revendication 10 **caractérisé en ce qu'**il comprend des moyens (614) pour compenser des décentrages en phase de la boucle du modulateur (600), une commande numérique (615) de contrôle de retard de la boucle étant déduite d'une comparaison entre une estimation de la réponse fréquentielle en boucle ouverte du modulateur et une réponse fréquentielle de référence.

**12.** Modulateur sigma-delta selon l'une quelconque des revendications 10 ou 11 **caractérisé en ce qu'**au moins un des modules de traitement du modulateur (601, 604, 608, 611) est instancié dans un circuit logique programmable de type FPGA.

**Patentansprüche**

**1.** Verfahren zum Verbessern von Auflösung und zum Korrigieren von Verzerrungen für einen Sigma-Delta-Modulator, wobei der Modulator (200) ein analoges Eingangssignal e(t) in ein zweites digitales Ausgangssignal s(t) umwandelt, das mit einer Frequenz $f_e$ abgetastet und auf $N_B = N_{MSB} + N_{LSB}$ Bits codiert wird, deren $N_{MSB}$ höchstwertige Bits MSB und deren $N_{LSB}$ geringstwertige Bits LSB sind, wobei die $N_{MSB}$ Bits MSB zum Modulator zurückgekoppelt werden, wobei das zurückgekoppelte Signal nach der Digital-Analog-Umwandlung der $N_{MSB}$ höchstwertigen Bits MSB erneut mit der Frequenz $f_e$ abgetastet wird, um ein zweites digitales Hauptausgangssignal s'(t) zu erzeugen, das auf $N_{MSB}$ Bits dargestellt ist, wobei das Verfahren **dadurch gekennzeichnet ist, dass** wenigstens drei Prozesse nacheinander am Ausgang des Modulators ausgeführt werden:

- ein erster Prozess (201) führt eine Demodulation mit einer Frequenz fo und eine Dezimierung von Faktor N auf unabhängige Weise (202, 203) an den zwei Signalen s(t) und s'(t) durch;
- ein zweiter Prozess (204) zum Verbessern der Auflösung wird auf das Ergebnis des ersten Prozesses (201) angewendet und ein dritter Prozess (208) zum Korrigieren von Verzerrungen wird auf das Ergebnis des zweiten Prozesses (204) angewendet, wobei der zweite und der dritte Prozess Filtervorgänge beinhalten, deren Impulsantworten von der Schätzung $\xi_0$(t) der Analogantwort $\xi$(t) im offenen Kreis des Modulators auf der Basis von Messungen der Impulsantwort $\xi_k$(t) im offenen Kreis abgeleitet werden, wobei die Messungen am Ende des Modulations- und Dezimierungsprozesses (201) durchgeführt werden.

**2.** Verfahren nach Anspruch 1, **dadurch gekennzeichnet, dass** die Zeitantwort $\xi_k$(t) des offenen Kreises des Modulators, entsprechend einer Frequenzantwort $\xi_k$(f), für verschiedene zusätzliche Kreisverzögerungswerte durch Anlegen einer Serie von gleichmäßig beabstandeten $2^K$xM Impulsen (308, 401) an den Eingang des Rückkopplungskreis-Digital-Analog-Wandlers (CNA) (304) gemessen wird und es zulässt, durch Beobachten eines vom ersten Prozess (201) kommenden Ausgangssignals ŝ(t), wobei das Signal von der Dezimierung resultiert, $2^K$ Serien von M aufeinanderfolgenden Messungen der Impulsantwort entsprechend $2^K$ unterschiedlichen Kreisverzögerungen zu bewirken, wobei diese M aufeinanderfolgenden Messungen dann gemittelt (500) werden, um $2^K$ Messwerte mit verbesserter Präzision bereitzustellen.

**3.** Verfahren nach Anspruch 2, **dadurch gekennzeichnet, dass** ein Rauschen b(t) mit einer Spitzenamplitude von gleich einem LSB-Bit während der Messungen der Verstärkung des Kreises $\xi_k$(t) stromaufwärts von dem das digitale Hauptausgangssignal s(t) erzeugenden Analog-Digital-Wandlers (CAN) (303) hinzugefügt (309) wird.

**4.** Verfahren nach Anspruch 2 oder 3, **dadurch gekennzeichnet, dass** jede der $2^K$ Messungen der $2^K$ Antworten $\xi_k$(t) mit einem spezifischen zeitlichen $J_k$(t) und frequenzmäßigen $J_k$(f) Antwortfilter gefiltert wird, um die Abweichung zwischen der Kreisverzögerung entsprechend dieser Messung von $\xi_k$(t) und der Kreisverzögerung entsprechend einer Messung von $\xi_0$(t) zu kompensieren.

5. Verfahren nach Anspruch 4, **dadurch gekennzeichnet, dass** die Antworten $J_k(t)$ gleich $[\delta + k \times J /2^K]$ sind, wobei $\delta$ eine Dirac-Antwort ist und J eine finite Approximation einer Abtastung mit $f_e/N$ des Derivats des Kardinalsinus $sinc[(f_e.t)/N]$ ist.

6. Verfahren nach Anspruch 4 oder 5, **dadurch gekennzeichnet, dass** die $2^K$ Messungen der Antwort $\xi_k(t)$ des Kreises nach dem Mitteln (500) und Interpolieren (501) durch Koeffizienten gleich $e^{j2\pi k f_0 T_e/2^K}$ gewichtet (502) werden, um eine Schätzung der analogen Frequenzantwort $\xi(f)$ im offenen Kreis des Modulators zu produzieren.

7. Verfahren nach einem der vorherigen Ansprüche, **dadurch gekennzeichnet, dass** der zweite Prozess (204) eine erste Filterung (205) mit einer Impulsantwort entsprechend einer dezimierten Antwort $H_0(f)$ des Demodulations-/Dezimierungsprozesses (201), wobei die Filterung auf das von der Demodulation/Dezimierung (202) von s(t) resultierende Signal $\hat{s}(t)$ angewendet wird, und eine zweite Filterung (206) mit einer Implusantwort gleich $\hat{\xi}_0(t)$ durchführt, wobei die Filterung auf das von der Demodulation/Dezimierung (203) von s'(t) resultierende Signal $\hat{s'}(t)$ angewendet wird, wobei ein digitales Signal r(t) mit verbesserter Auflösung dann durch Addieren (207) der von den beiden Filtervorgängen resultierenden Signale erzeugt wird.

8. Verfahren nach einem der vorherigen Ansprüche, **dadurch gekennzeichnet, dass** der dritte Prozess (208) ein Hauptfilter (209) gefolgt von einem zusätzlichen auf das Signal r(t) angewandten Filter (210) umfasst, wobei das Hauptfilter eine Impulsantwort entsprechend der Umkehr der Frequenzantwort $H_0(f).\xi(f)$ hat, und das zusätzliche Filter eine Impulsantwort entsprechend $sinc[(f+f_0)/f_e]$ im nützlichen Band des verarbeiteten Signals hat.

9. Verfahren nach Anspruch 8, **dadurch gekennzeichnet, dass** die Länge der Impulsantwort des zusätzlichen Filters des Prozesses zum Korrigieren von Verzerrungen durch Verbinden des Spektrums im Rest des Nyquist-Bandes außerhalb des nützlichen Bandes des verarbeiteten Signals reduziert wird.

10. Sigma-Delta-Modulator, der wenigstens einen Wandlungskreis (600) zum Umwandeln eines analogen Signals e(t) in ein digitales Ausgangssignal s(t) umfasst, wobei der Kreis zusammengesetzt ist aus wenigstens einem Integrator (100), einem ersten Analog-Digital-Wandler (CAN) (103), der ein Ausgangssignal s(t) erzeugt, einem Rückkopplungskreis-Digital-Analog-Wandler (CAN) (104), einem Addierer-Subtrahierer (105) und einem zweiten Analog-Digital-Wandler (CAN) (106) zum erneuten Abtasten des Ausgangs des Rückkopplungskreis-Wandlers und zum Erzeugen eines zweiten digitalen Ausgangssignals s'(t), wobei der Modulator **dadurch gekennzeichnet ist, dass** er eine Vorrichtung zum Verbessern der Auflösung und zum Korrigieren von Verzerrungen umfasst, die das Verfahren nach einem der vorherigen Ansprüche ausführt und wenigstens Folgendes umfasst:

   - ein Modulations-/Dezimierungsmodul (601), das die Signale s(t) und s'(t) durch unabhängiges Filtern verarbeitet, um wenigstens zwei Ausgangssignale $\hat{s}(t)$ und $\hat{s'}(t)$ zu erzeugen;
   - ein Modul (604) zum Verbessern der Auflösung, das die Signale $\hat{s}(t)$ und $\hat{s'}(t)$ filtert, um ein digitales Ausgangssignal r(t) zu erzeugen;
   - ein Modul (608) zum Korrigieren von Verzerrungen, das das Signal r(t) filtert und das digitale Ausgangssignale c(t) des Sigma-Delta-Modulators erzeugt;
   - ein Modul (611) zum Messen von digitalen Antworten $\xi_k(t)$ im offenen Kreis des Wandlungskreises (600), das die analoge Antwort $\xi(t)$ im offenen Kreis der Messungen ableitet, um die Impulsantworten von Filtern in den Modulen zum Verbessern der Auflösung und zum Korrigieren von Verzerrungen (604 bzw.608) zu kalibrieren.

11. Sigma-Delta-Modulator nach Anspruch 10, **dadurch gekennzeichnet, dass** er Mittel (614) zum Kompensieren von Phasenverschiebung des Kreises des Modulators (600), eine digitale Steuerung (615) zum Regeln von Kreisverzögerung umfasst, abgeleitet von einem Vergleich zwischen einer Schätzung der Frequenzantwort im offenen Kreis des Modulators und einer Referenzfrequenzantwort.

12. Sigma-Delta-Modulator nach Anspruch 10 oder 11, **dadurch gekennzeichnet, dass** wenigstens eines der Verarbeitungsmodule (601, 604, 608, 611) des Modulators in einer programmierbaren Logikschaltung des FPGA-Typs instanziiert wird.

**Claims**

1. A method for improving resolution and for correcting distortions for a sigma-delta modulator, said modulator (200) converting an analogue input signal e(t) into a secondary digital output signal s(t) sampled at a frequency $f_e$ and

coded on $N_B = N_{MSB} + N_{LSB}$ bits, of which $N_{MSB}$ are most significant bits MSB and $N_{LSB}$ are least significant bits LSB, said $N_{MSB}$ bits MSB being fedback to said modulator, the fedback signal after digital-analogue conversion of said $N_{MSB}$ most significant bits MSB being re-sampled at the frequency $f_e$ so as to generate a second main digital output signal s'(t) represented on $N_{MSB}$ bits, said method being **characterised in that** at least three processes are successively applied at the output of said modulator:

- a first process (201) carries out a demodulation by a frequency $f_0$ and a decimation of factor N in an independent manner (202, 203) on said two signals s(t) and s' (t);
- a second process (204) for improving resolution is applied to the result of said first process (201) and a third process (208) for correcting distortions is applied to the result of said second process (204), said second and third processes comprising filtering operations, the pulse responses of which are derived from the estimate $\xi_0(t)$ of the open-loop analogue response $\xi(t)$ of said modulator based on measurements of the open-loop pulse response $\xi_k(t)$, said measurements having been carried out at the end of said demodulation and decimation process (201).

2. The method according to claim 1, **characterised in that** the temporal response $\xi_k(t)$ of the open-loop of the modulator that corresponds to a frequency response $\xi_k(f)$ is measured for various values of additional loop delays by applying a series of $2^K \times M$ pulses (308, 401) to the input of the loop feedback digital-analogue converter (CNA) (304), which pulses are regularly spaced apart and allow, by observing an output signal $\hat{s}(t)$ coming from said first process (201), said signal resulting from said decimation to carry out $2^K$ series of M successive measurements of the pulse response corresponding to $2^K$ different loop delays, these M successive measurements then being averaged (500) so as to provide $2^K$ measurements with improved precision.

3. The method according to claim 2, **characterised in that** a noise b(t) with a peak amplitude that is equal to one LSB bit is added (309) during the measurements of the gain of the loop $\xi_k(t)$ upstream of the analogue-digital converter (CAN) (303) producing said main digital output signal s(t).

4. The method according to claim 2 or 3, **characterised in that** each of the $2^K$ measurements of the $2^K$ responses $\xi_k(t)$ is filtered by a specific temporal $J_k(t)$ and frequency $J_k(f)$ response filter intended to compensate the deviation between the loop delay that corresponds to this measurement of $\xi_k(t)$ and the loop delay that corresponds to the measurement of $\xi_0(t)$.

5. The method according to claim 4, **characterised in that** the responses $J_k(t)$ are equal to $[\delta + k \times J /2^K]$, where $\delta$ is a Dirac response and J is a finite approximation of a sampling at $f_e/N$ of the derivative of the cardinal sinc$[(f_e.t)/N]$.

6. The method according to claim 4 or 5, **characterised in that** the $2^K$ measurements of the response $\xi_k(t)$ of the loop after averaging (500) and interpolating (501) are weighted (502) by coefficients equalling $e^{j2\pi k f_0 T_e/2^K}$ in order to produce an estimate of the open-loop analogue frequency response $\xi(f)$ of said modulator.

7. The method according to any one of the preceding claims, **characterised in that** said second process (204) carries out a first filtering operation (205) using a pulse response that corresponds to a decimated response $H_0(f)$ of the demodulation/decimation process (201), said filtering operation being applied to the signal $\hat{s}(t)$ resulting from the demodulation/decimation (202) of s(t), a second filtering operation (206) using a pulse response equal to $\xi_0(t)$, said filtering operation being applied to the signal $\hat{s}'(t)$ resulting from the demodulation/decimation (203) of s'(t), a digital signal r(t) with improved resolution is then generated by adding (207) the signals resulting from the two filtering operations.

8. The method according to any one of the preceding claims, **characterised in that** said third process (208) comprises a main filter (209) followed by an additional filter (210) applied to said signal r(t), said main filter having a pulse response that corresponds to the inverse of the frequency response $H_0(f).\xi(f)$ and the additional filter having a pulse response that corresponds to sinc$[f+f_0)/f_e]$ in the useful band of the processed signal.

9. The method according to claim 8, **characterised in that** the length of the pulse response of the additional filter of the process for correcting distortions is reduced by connecting the spectrum in the remainder of the Nyquist band outside of the useful band of the processed signal.

10. A sigma-delta modulator comprising at least one conversion loop (600) converting an analogue signal e(t) into a digital output signal s(t), said loop being made up of at least one integrator (100), a first analogue-digital converter (CAN) (103) generating an output signal s(t), a loop feedback digital-analogue converter (CAN) (104), an adder-subtractor (105) and a second analogue-digital converter (CAN) (106) re-sampling the output of the loop feedback converter and generating a second digital output signal s'(t), said modulator being **characterised in that** it comprises a device for improving resolution and for correcting distortions implementing the method according to any one of the preceding claims and comprising at least:

- a modulation/decimation module (601) processing, through independent filtering operations, said signals s(t) and s'(t) so as to generate at least two output signals $\hat{s}(t)$ and $\hat{s}'(t)$;
- a module (604) for improving resolution filtering said signals $\hat{s}(t)$ and $\hat{s}'(t)$ so as to produce a digital output signal r(t);
- a module (608) for correcting distortions filtering the signal r(t) and producing the digital output signal c(t) of said sigma-delta modulator;
- a module (611) for measuring open-loop digital responses $\xi_k(t)$ of said conversion loop (600) by deducing the open-loop analogue response $\xi(t)$ of said measurements in order to calibrate the pulse responses of filters included in the modules for improving resolution and for correcting distortions (604, 608, respectively).

11. The sigma-delta modulator according to claim 10, **characterised in that** it comprises means (614) for compensating any phase-shifting of the loop of said modulator (600), a digital control (615) for controlling loop delay being deduced by a comparison between an estimate of the open-loop frequency response of said modulator and a reference frequency response.

12. The sigma-delta modulator according to claim 10 or 11, **characterised in that** at least one of the processing modules (601, 604, 608, 611) of said modulator is instantiated in a programmable logic circuit of the FPGA type.

FIG.1

FIG.2

FIG.3

FIG.4

FIG.5

FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2907988 A1

**Littérature non-brevet citée dans la description**

- **T.C. LESLIE ; B. SINGH.** An improved $\Sigma\Delta$ modulatorarchitecture. *IEEE Proc. ISCAS'90,* Mai 1990, vol. 1, 372-375

- Delta-Sigma Data Converters. IEEE Press, 273-275